# FASCICULE DE BREVET EUROPEEN

(11) **EP 2 143 149 B1**
(45) Date de publication et mention de la délivrance du brevet: **21.12.2011**
(21) Numéro de dépôt: 08788194.2
(22) Date de dépôt: 17.04.2008
(51) Int. Cl.: H01L 31/05, H01L 31/02, H01L 31/048, H01L 31/042

(54) **BÂTI SUPPORT D'UN PANNEAU ÉLECTRIQUEMENT ACTIF TEL QU'UN PANNEAU PHOTOVOLTAÏQUE**
TRAGERAHMEN FÜR EINE ELEKTRISCH AKTIVE TAFEL, Z. B. EINE PHOTOVOLTAISCHE TAFEL
BEARING FRAME FOR AN ELECTRICALLY ACTIVE PANEL SUCH AS PHOTOVOLTAIC PANEL

(30) Priorité: 20.04.2007 FR 0754616
(43) Date de publication de la demande: 13.01.2010
(73) Titulaire: Aperam Alloys Imphy, 93200 Saint Denis (FR); Solarte, 66500 Ria Sirach (FR)
(72) Inventeur: REYAL, Jean-Pierre, F-95610 Eragny (FR); JAUTARD, Yves, F-66820 Vernet Les Bains (FR)
(74) Mandataire: Domenego, Bertrand
(86) Numéro de dépôt international: PCT/FR2008/050681
(87) Numéro de publication internationale: WO 2008/145898

(56) Documents cités:
- EP-A- 0 325 369
- EP-A- 1 120 837
- EP-A- 1 341 240
- GB-A- 2 391 704
- US-A- 4 283 106
- US-A1- 2001 050 102
- US-A1- 2002 078 991

## Description

L'invention est relative à un bâti support d'un panneau, du type comprenant une structure périphérique destinée à recevoir un panneau électriquement actif tel qu'un panneau de cellules photovoltaïques. Ce bâti support d'un panneau est destiné en particulier à supporter des panneaux électriquement actifs disposés sur une paroi d'un bâtiment, tel qu'un toit ou une façade.

Afin d'équiper des bâtiments tels que des maisons, de générateurs d'électricité utilisant l'énergie solaire, on dispose, par exemple sur le toit de ces bâtiments, des ensembles de panneaux constitués d'une pluralité de cellules photovoltaïques.

Ces panneaux sont constitués en général d'un empilage de diverses couches de verre, de silicium, de conducteurs et de polymères. Les cellules de silicium, généralement carrées, ont une dimension pouvant atteindre 200 mm de côté. Les cellules sont assemblées en série puis collées entre deux feuilles de verre ou entre une feuille de verre et diverses couches de polymère. A titre d'exemple, un module de tension nominal de 12 V est généralement composé par la mise en série de 36 cellules monocristallines ou polycristallines. Ces assemblages de 36 cellules sont ensuite assemblés en parallèle. Dans le cas d'un module de 24 V, on utilise alors 72 cellules de silicium.

De tels panneaux ou modules ont une face avant constituée de verre, dirigée vers le soleil, destinée à faire passer le rayonnement de façon à ce qu'il puisse interagir avec les cellules de silicium et générer de l'électricité. Cette plaque de verre sert également à protéger les cellules photovoltaïques des impacts divers. La face arrière des modules ou panneaux peut être soit opaque et constituée d'un empilement complexe de polymères destiné à protéger les cellules des agressions mécaniques et de la corrosion, soit être transparente, la face arrière étant alors une plaque de verre.

Ces modules ou panneaux photovoltaïques sont disposés sur des cadres dont les montants sont généralement constitués de profilés en aluminium assemblés, qui leur confèrent une rigidité mécanique et qui permet de les fixer sur le toit. En outre, les panneaux sont connectés entre eux ainsi qu'avec un circuit de distribution destiné à alimenter les utilisations de l'électricité.

En général, les connexions se font à l'arrière des panneaux photovoltaïques, par l'intermédiaire de faisceaux de câble s'étendant sous les panneaux photovoltaïques. Lorsque les panneaux photovoltaïques sont transparents, ces faisceaux de câble sont particulièrement disgracieux, ce qui présente un inconvénient notamment lorsque les panneaux photovoltaïques sont destinés à être placés en façade de bâtiment. En effet, de tels panneaux transparents peuvent être utilisés comme moyens d'ornementation, et la présence de faisceaux de câble à l'arrière visibles en transparence rend ces panneaux inadaptés à un tel usage.

Ce problème peut se rencontrer également pour d'autres panneaux électriquement actifs, par exemple des panneaux électroluminescents ou des panneaux pouvant comporter des éléments tels que des écrans plats.

Par ailleurs, les cadres en aluminium sont plutôt volumineux du fait des faibles propriétés mécaniques de l'aluminium, et ils peuvent avoir des comportements à la corrosion qui ne sont pas toujours satisfaisants. En outre, ils demandent beaucoup de main d'oeuvre pour leur mise en place et notamment pour la réalisation des connexions électriques.

Enfin, en cas de fortes chutes de neiges, les cades en aluminium peuvent être arrachés par le glissement de plaques de neige.

Le but de la présente invention est de remédier à ces inconvénients en proposant des moyens pour supporter des panneaux électriquement actifs tels que des panneaux ou des modules photovoltaïques qui permettent d'effectuer des connexions facilement et sans détériorer l'esthétique des surfaces constituées par ces ensembles de panneaux.

A cet effet, l'invention a pour objet un bâti support d'un panneau, du type comprenant une structure périphérique destinée à recevoir un panneau électriquement actif. La structure périphérique comprend un moyen de connexion électrique intérieur permettant la connexion avec un panneau électriquement actif porté par le bâti, au moins un premier moyen de connexion électrique extérieur permettant une connexion avec un premier moyen extérieur au bâti, et des moyens de liaison électrique pour relier électriquement au moins le moyen de connexion électrique intérieur avec au moins le premier moyen de connexion électrique extérieur, les moyens de liaison électrique s'étendant le long de la structure périphérique, afin d'être dissimulés par la structure périphérique.

De préférence, la structure périphérique comprend une partie creuse dans laquelle les moyens de liaison électrique sont reçus.

La structure périphérique est par exemple un cadre constitué de montants tubulaires, les moyens de connexion électrique s'étendant à travers la paroi des montants sur lesquels il sont disposés et les moyens de liaison électrique s'étendant à l'intérieur des montants tubulaires.

Les montants peuvent comporter une gorge s'étendant le long d'une de leur génératrice, orientée vers l'intérieur du cadre, et destinée à recevoir le bord d'un panneau électriquement actif.

Au moins un montant peut comporter sur toute sa longueur un volet s'étendant vers l'extérieur du cadre.

De préférence, la partie centrale du bâti délimitée par la structure périphérique est ouverte.

De préférence, le bâti est constitué d'une bande métallique découpée, pliée et assemblée par soudage, par exemple en acier.

De préférence, la bande métallique est constituée d'un alliage inoxydable et/ou d'un alliage ayant un coefficient de dilatation compatible avec le verre.

De préférence, le bâti comprend deux moyens de connexion électrique extérieur comprenant chacun au moins deux bornes, et mieux , au moins trois bornes et le moyen de connexion électrique intérieur comporte deux bornes, chaque borne du moyen de connexion électrique intérieur étant relié à une borne de chacun des moyens de connexion électrique extérieure, et chaque borne d'un moyen de connexion électrique extérieure, non reliée à une borne du moyen de connexion électrique intérieure est relié électriquement à une borne de l'autre moyen de connexion électrique extérieure non reliée à une borne du moyen de connexion électrique intérieur.

Le moyen de connexion électrique intérieur peut comporter des demi-boucles femelles élastiques destinées à recevoir des plots mâles prévus sur la tranche d'un panneau électriquement actif.

Le panneau électriquement actif est par exemple un générateur photovoltaïque.

L'invention concerne également une paroi extérieure d'un bâtiment qui comporte une pluralité de bâtis selon l'invention disposés les uns à côté des autres. Au moins deux bâtis adjacents sont connectés entre eux par un moyen de liaison électrique extérieur coopérant d'une part avec un moyen de connexion électrique extérieur d'un bâti et d'autre part avec un moyen de connexion extérieur de l'autre bâti.

Au moins un bâti porte un panneau électriquement actif qui est par exemple un générateur photovoltaïque.

La paroi extérieure d'un bâtiment constitue par exemple un élément de toiture.

L'invention va maintenant être décrite de façon plus précise mais non limitative en regard des figures annexées dans lesquelles :
- la figure 1 est une vue en perspective d'un bâti support d'un panneau électriquement actif ;

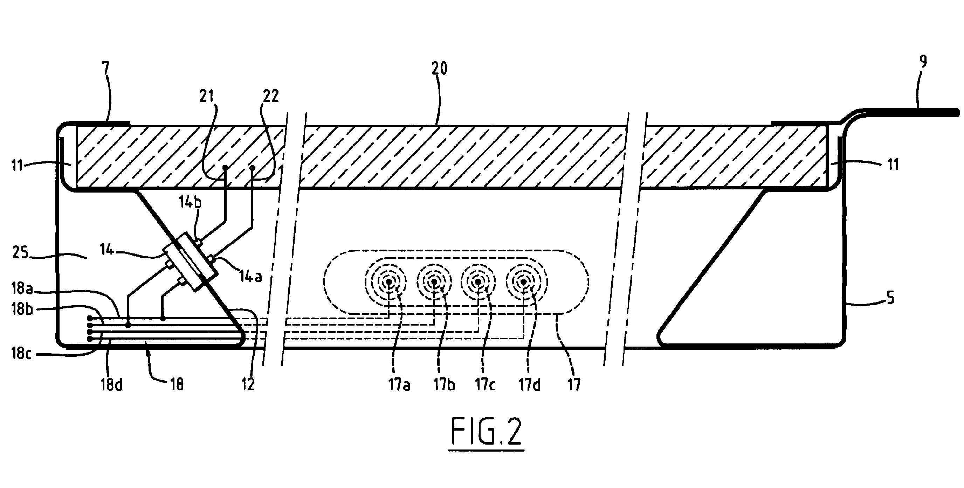

- la figure 2 est une vue en coupe du bâti de la figure 1 sur lequel est monté un panneau électriquement actif ;
- la figure 3 est une vue schématique d'une bande métallique découpée et pré pliée destinée à la fabrication d'un bâti de support d'un panneau électriquement actif tel que représenté à la figure 1 ;
- la figure 4 est une vue en perspective d'une phase intermédiaire de fabrication d'un bâti support d'un panneau électriquement actif à l'aide d'une bande métallique représentée à la figure 3 ;

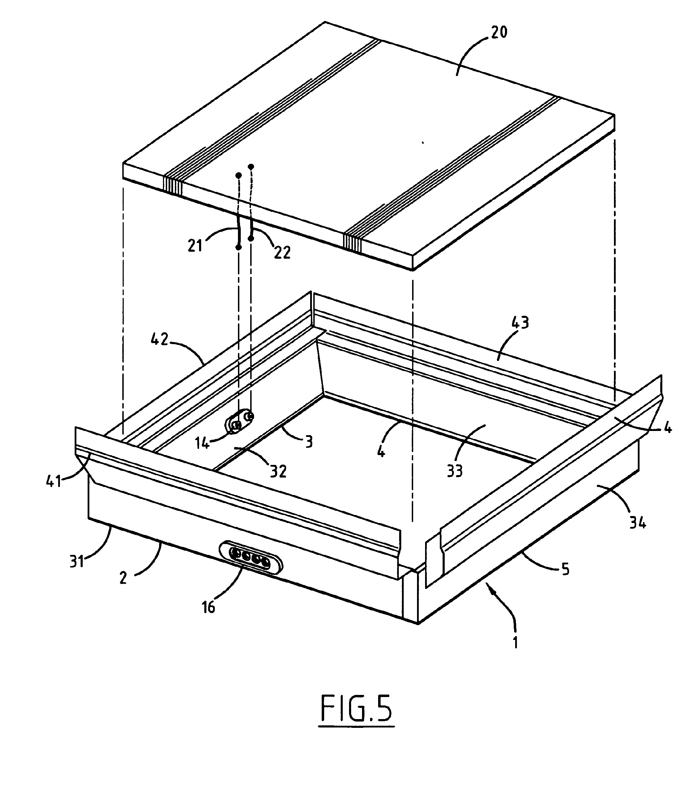

- la figure 5 est une vue éclatée d'un bâti support d'un panneau électriquement actif sur lequel on monte un panneau électriquement actif ;
- la figure 6 est une vue schématique d'un mode de connexion d'un ensemble de panneaux photovoltaïques monté sur le toit d'un bâtiment ;
- la figure 7 est une vue schématique d'un deuxième mode de branchement d'un ensemble de panneaux photovoltaïques monté sur un toit d'un bâtiment ;
- la figure 8 est une représentation schématique des moyens de connexion de deux panneaux photovoltaïques adjacents destinés à être montés sur la paroi d'un bâtiment ;
- la figure 9 est une vue schématique d'un moyen de connexion d'un panneau photovoltaïque ;
- les figures 10, 11 et 12 représentent trois modes de réalisation de dispositif de connexion entre deux panneaux photovoltaïques adjacents ;
- la figure 13 est une vue en coupe d'un mode de réalisation d'une connexion d'un panneau électriquement actif avec un moyen de connexion interne d'un bâti.

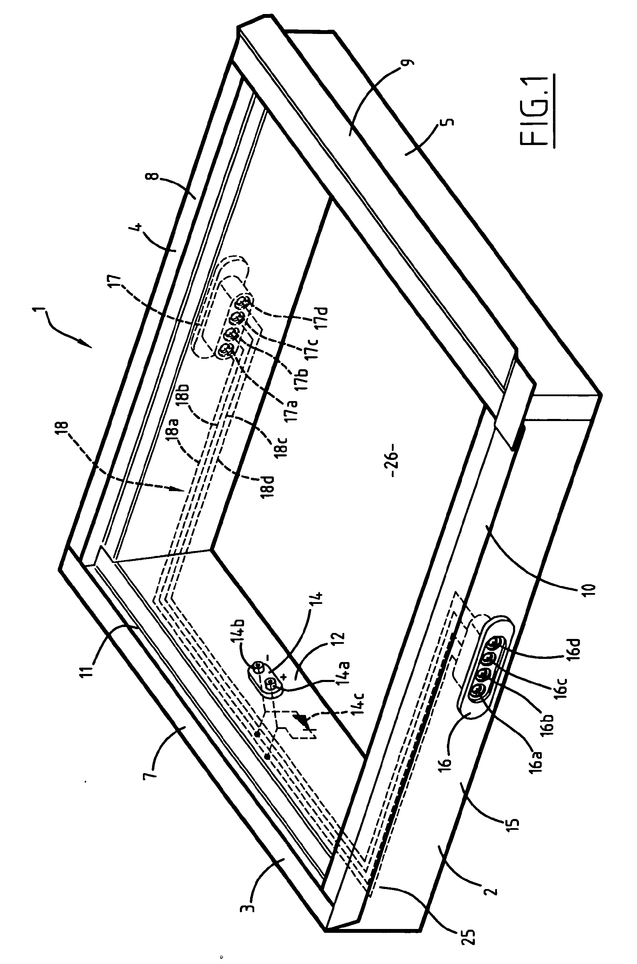

Le bâti support d'un panneau électriquement actif comprend une structure périphérique, repéré généralement par 1 à la figure 1, en forme de cadre rectangulaire constituée de quatre montants 2, 3, 4, 5. Ces montants comportent à leurs parties supérieures des volets horizontaux 7, 8, 9, 10 rabattus vers l'intérieur et qui délimitent à la périphérie du cadre une gorge 11 destinée à recevoir un panneau électriquement actif tel qu'un panneau de cellules photovoltaïques. Deux des volets 9, 10 s'étendent également vers l'extérieur du cadre de façon à former des ailes sont destinées à assurer l'étanchéité entre deux bâtis adjacents.

Chaque montant 2, 3, 4, 5 du cadre qui constitue la structure périphérique est creux et réalisé comme cela sera expliqué ultérieurement par pliage d'une bande métallique, de façon à pouvoir recevoir des moyens de connexion électrique.

La paroi intérieure 12 du montant 3, comporte un connecteur 14 comprenant deux plots 14a et 14b permettant le branchement d'un panneau électriquement actif supporté par le bâti. En particulier, lorsque ce panneau électriquement actif est une cellule photovoltaïque 20, les branchements positifs et négatifs 21 et 22 du panneau photovoltaïque peuvent être branchés sur les plots 14a et 14b du connecteur 14. Ce connecteur 14 est par exemple un connecteur comprenant un corps en matière plastique surmoulé dans un trou prévu sur la face 12 du montant 3.

La face externe du montant 2, perpendiculaire au montant 3, comporte un moyen de connexion externe 16 également surmoulé dans un trou prévu sur la paroi 15 du montant 2. Ce moyen de connexion externe comporte quatre plots de connexion 16a, 16b, 16c et 16d. De la même façon, il est prévu sur la paroi externe du montant 4 opposé au montant 2 (non visible sur la figure), un deuxième moyen de connexion externe 17 également surmoulé comportant également quatre plots de connexion 17a, 17b, 17c et 17d.

Les différents plots des moyens de connexion externe 16 et 17 et du moyen de connexion interne 14 sont reliés entre eux par un moyen de liaison électrique 18. Ce moyen de liaison électrique comporte un premier câble de connexion 18a qui relie un premier plot de connexion 16a d'un moyen de connexion externe 16, et le premier plot de connexion 17a du moyen de connexion externe 17 et qui est également connecté à un premier plot de connexion 14a du moyen de connexion interne 14.

Un deuxième câble de connexion 18b relie le deuxième plot 16b du moyen de connexion externe 16, le deuxième plot 17b du moyen de connexion externe 17, ainsi que le deuxième plot de connexion 14b du moyen de connexion interne 14.

Un troisième câble 18c relie directement le troisième plot de connexion du moyen de connexion externe 16, avec le troisième plot 17c du deuxième moyen du moyen de connexion externe 17.

Enfin, un quatrième câble de connexion 18d relie directement le quatrième plot de connexion 16d du moyen de connexion externe 16 avec le quatrième plot 17d du moyen de connexion externe 17.

Ces deux derniers circuits de connexion ne sont pas connectés aux moyens de connexion interne 14.

En outre, les connecteurs internes positifs 14a et négatif 14b peuvent être connectés par l'intermédiaire d'une diode 14c orientée de façon à bloquer le passage du courant du connecteur positif vers le connecteur négatif et à permettre le passage du courant en sens inverse. Cette diode permet, lorsque c'est nécessaire, de bipasser un panneau photovoltaïque défectueux.

Ces circuits de connexion sont situés à l'intérieur des montants creux et sont donc complètement dissimulés.

Les moyens de connexion interne, externe et les circuits de connexion entre ces différents moyens de connexion permettent de connecter entre eux des ensembles de panneaux, comme cela sera expliqué ultérieurement, de façon, par exemple lorsqu'il s'agit de panneaux générateur d'électricité, à réaliser des montages en série ou des montages en parallèle.

Comme on l'a indiqué précédemment, les montants 2, 3, 4 et 5 constituent un cadre qui forme la structure périphérique creuse qui entoure une partie centrale 26 qui est en général ouverte. Cependant, rien ne s'oppose à ce que cette partie centrale 26 soit fermée par un panneau.

Avec cette disposition, le moyen de liaison électrique 18 est entièrement reçu dans une partie creuse 25 du bâti constitué par l'intérieur des montants tubulaires, et ainsi dissimulé.

Outre les liaisons électriques nécessaires à l'utilisation des panneaux photovoltaïques, le bâti peut incorporer un moyen de chauffage électrique (non représenté) destiné à maintenir le bâti à une température supérieure à 0°C, et de préférence supérieure à 7 ou 8°C.

Ce moyen de chauffage qui peut être constitué de façon connue d'une résistance électrique chauffante commandée par détecteur de température, est utile en hiver pour pouvoir décoller de la neige qui viendrait occulter les panneaux.

Le moyen de connexion électrique interne 14 tel que représenté, est adapté à la connexion de panneaux photovoltaïques comportant deux fils de liaison électrique.

En outre, on peut prévoir une cosse fixée directement sur le bâti et permettant la mise à la terre de celui-ci.

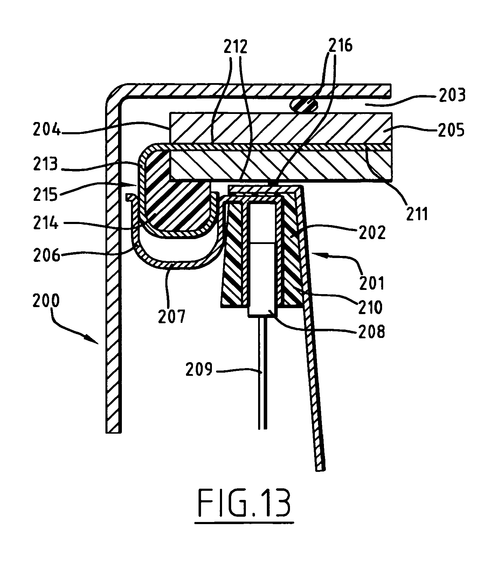

D'autres moyens de connexion électrique interne peuvent être envisagés. On va maintenant décrire un mode de réalisation particulier d'un tel mode de connexion, représenté à la figure 13.

Le montant 200 du bâti comporte un connecteur intérieur 201 incorporé dans la face inférieure 202 de la gorge 203 qui reçoit le bord 204 du panneau photovoltaïque 205. Des joints élastiques 216 sont disposés entre le panneau photovoltaïque et les faces inférieures et supérieures de la gorge 203. Ces joints élastiques servent à assurer l'étanchéité et à permettre les déplacements résultant de dilatation différentielle

Le connecteur 201 est constitué d'au moins deux cosses 206 (une seule visible sur la figure) en matériau conducteur comprenant chacune une demi-boucle femelle élastique 207 et un plot 208 de liaison avec un conducteur électrique 209. Les deux ou trois cosses sont noyées dans un enrobage 210 en matière plastique destinées à fixer les cosses sur la paroi du montant du cadre.

Le panneau photovoltaïque 205 comprend une tranche active 211 enserrée entre deux plaques support et de protection 212. La tranche active 211 est prolongée à l'extérieur par deux ou trois bandes conductrices 213 en cuivre (une seule visible sur la figure) qui s'enroulent autour d'un corps en matière plastique 214 de façon à former un plot de connexion mâle 215 adapté pour pouvoir se clipser dans les boucles femelles 207 des cosses 206 du connecteur 201 du cadre.

Le connecteur intérieur 201 et le plot de connexion mâle 215 sont adaptés pour que, lorsque le plot de connexion mâle 215 est enfiché dans le connecteur intérieur 201, chaque bande conductrice 213 du panneau photovoltaïque est en contact électrique avec une demi-boucle femelle élastique du connecteur intérieur.

On comprendra que le dispositif de connexion comprend au moins une cosse pour le pôle positif et une cosse pour le pôle négatif.

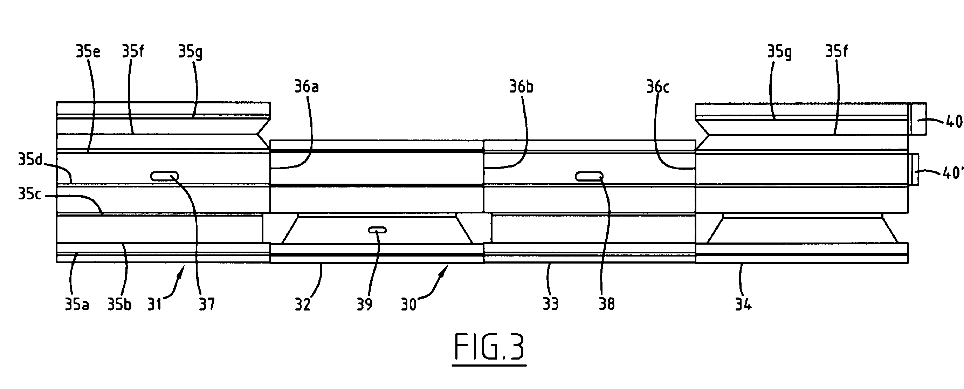

Pour réaliser un bâti support d'un panneau, du type comprenant une structure périphérique creuse telle qu'elle vient d'être décrite, on utilise une bande métallique 30 (représentée à la figure 3) pré découpée, et comprenant quatre panneaux 31, 32, 33, 34 séparés par des lignes de pliage verticales 36a, 36b et 36c et destinés chacun, après pliage, à former les montants respectivement 2, 3, 4 et 5. Cette bande 30 comporte des lignes de pliage horizontales 35a, 35b, 35c, 35d, 35e, 35f et 35g s'étendant sur l'ensemble de la longueur de la bande et qui permettront d'effectuer des pliages de façon à former des ensembles tubulaires. La bande métallique comporte au moins une patte de soudage 40'.

Le panneau 31 comporte une ouverture 37 destinée à recevoir le moyen de connexion externe 16.

Le panneau 32 comporte une ouverture 39 destinée à recevoir le moyen de connexion interne 14.

Le panneau 33 comporte une ouverture 38 destinée à recevoir le moyen de connexion externe 17.

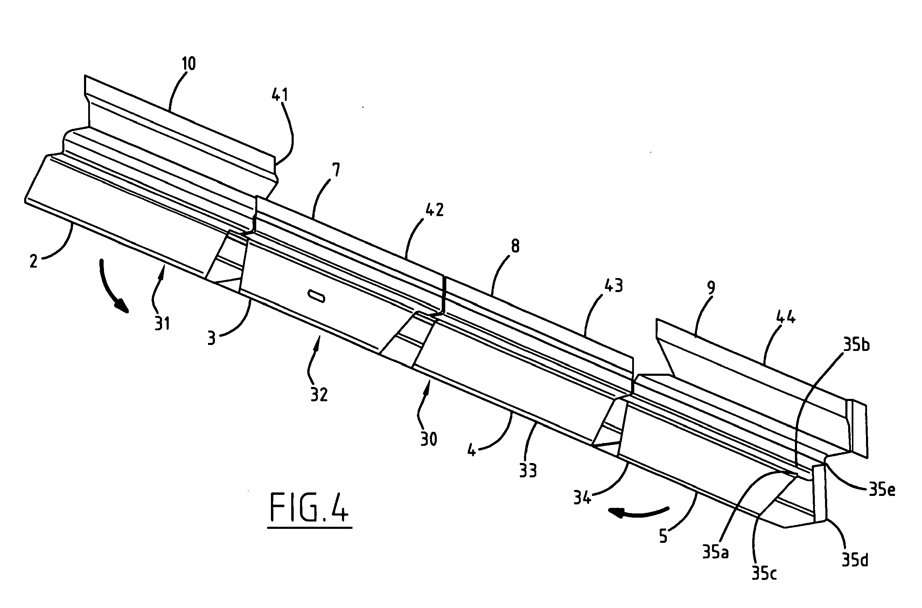

Comme représenté à la figure 4, dans une phase intermédiaire de fabrication, la bande pré découpée 30 peut être repliée selon des lignes de pliage longitudinales 35a, 35b 35c, 35d, 35e, notamment pour former des ensembles tubulaires correspondant aux panneaux 31, 32, 33 et 34. Cet ensemble peut alors être replié autour des lignes de pliage verticales 36a, 36b, 36c (non visibles sur la figure) de façon à reformer une structure fermée de forme généralement rectangulaire.

Les panneaux comportent des rabats 41, 42, 43, 44 qui, après pliage, peuvent former les volets 10, 7, 8 et 9 respectivement.

Naturellement, après pliage, les panneaux sont fixés par soudage de façon à former une structure rigide.

Une technique de fabrication de tels cadres obtenue par pliage d'une bande métallique pré découpée et pré pliée, est connue en elle-même et décrite par exemple dans la demande de brevet FR 00 09334.

Cette technique a l'avantage de permettre de fabriquer des cadres ou des structures creuses, très légères et en même temps extrêmement rigides. Cette technique en outre permettre d'automatiser facilement la fabrication de telles structures. On notera que notamment lorsque le cadre à fabriquer est très grand, on peut utiliser non pas une seule bande, mais plusieurs bandes. Chaque bande est utilisée pour réaliser une partie de cadre et les différentes parties sont, ensuite, assemblées.

Pour fabriquer un cadre, on prépare d'abord une bande prédécoupée avec des lignes de pré pliage et des emboutis nécessaires. Puis, on met en place les connecteurs surmoulés sur les panneaux 31, 32 et 33. On pose alors l'ensemble 18 de câbles de connexion.

On effectue les pliages longitudinaux pour constituer des tubes profilés, des câbles étant situés à l'intérieur du tube.

On effectue des soudages lasers longitudinaux.

On plie alors les quatre segments de tubes le long des lignes de liaison de façon à refermer le cadre et on solidarise l'ensemble par des soudures laser, notamment sur la patte de soudage 40'.

L'homme du métier sait réaliser une telle fabrication.

La structure telle qu'elle vient d'être décrite une fois qu'elle est réalisée de façon à former un ensemble rectangulaire avec les rabats 41, 42, 43 et 44, peut recevoir un panneau électrique tel qu'un panneau photovoltaïque 20 que l'on vient déposer à l'intérieur du cadre et que l'on branche en connectant les conducteurs électriques 21 et 22 de sortie de cellule photovoltaïque aux plots 14a et 14b du moyen de connexion interne 14. Une fois le panneau photovoltaïque disposé à l'intérieur du cadre et branché, on peut rabattre les rabats 41, 42, 43 et 44 et les souder aux quatre coins de façon à assurer un maintien ferme du panneau 20 dans le cadre ou sur le bâti.

Afin de pouvoir supporter dans de bonnes conditions des panneaux photovoltaïques soumis aux intempéries, la bande métallique doit être constituée d'un alliage ayant des caractéristiques mécaniques élevées, un coefficient de dilatation de préférence compatible avec le verre et qui, de préférence, ait une bonne résistance à la corrosion atmosphérique. Le choix d'un coefficient de dilatation compatible avec celui du verre a pour but d'éviter le cisaillement des joints d'étanchéité disposés à la jonction entre les bâtis et les panneaux photovoltaïques.

L'alliage peut être par exemple du type N485 défini dans la norme ISO 63 72, dont le coefficient de dilatation, de l'ordre de 9,1 x 10⁻⁶/K entre 0 et 100°C, est proche de celui du verre et dont la limite d'élasticité est de l'ordre de 250 MPa. Lorsque le cadre est fabriqué avec cet alliage dont la composition chimique comprend essentiellement environ 48% de nickel, 6% de chrome et 45% de fer, il doit être protégé contre la corrosion.

L'alliage peut également être un acier inoxydable du type 316 par exemple tel que défini dans la norme NF EN 10088-2, dont le coefficient de dilatation, de l'ordre de 16 x 10⁻⁶/K entre 0°C et 100°C, est supérieur à celui du verre et la limite d'élasticité de l'ordre de 200 MPa. Cet acier qui contient environ 18% de chrome, 10% de nickel et 3% de molybdène, a une très bonne résistance à la corrosion. Mais, du fait de son coefficient de dilation élevé, il nécessite de disposer un joint élastomère entre le panneau photovoltaïque et le cadre pour compenser les écarts de dilatation.

Un autre alliage qui peut être utilisé est l'acier F18 MT défini dans la norme NF EN 10088-2 dont le coefficient de dilation, de l'ordre de 10,8 x 10⁻⁶/K entre 0°C et 100°C, est proche de celui du verre, dont la limite d'élasticité est de l'ordre de 220 MPa à l'état adouci, et dont la tenue à la corrosion est acceptable. Cet acier contient environ 18% de chrome, 2% de molybdène et 0,5% de titane et/ou de niobium.

Cette liste d'alliages possible n'est pas limitative et l'homme du métier pourra choisir l'alliage qu'il considère le mieux adapté à chaque application particulière.

En particulier, un acier classique du type acier au carbone, peut être utilisé.

En revanche, l'utilisation d'alliages d'aluminium n'est pas préférée, car ces alliages ne permettent pas d'obtenir une rigidité suffisante.

Comme on l'a indiqué précédemment, de tels bâtis munis de panneaux photovoltaïques peuvent être installés sur des parois d'un bâtiment, en particulier sur un pan de toit. Ces panneaux sont montés et fixés par des moyens de fixation adaptés et qui assurent l'étanchéité, et qui peuvent être constitués de longerons, de vis et de joints (non représentés) mais qui peuvent par exemple être les mêmes que les moyens supports utilisé pour fixer des cadres de support de panneaux photovoltaïques connus de l'état de la technique.

Les panneaux qui sont montés sur une paroi d'un bâtiment doivent alors être connectés entre eux de façon à pouvoir être reliés à une utilisation de l'énergie fournie lorsqu'il s'agit de panneaux photographiquement.

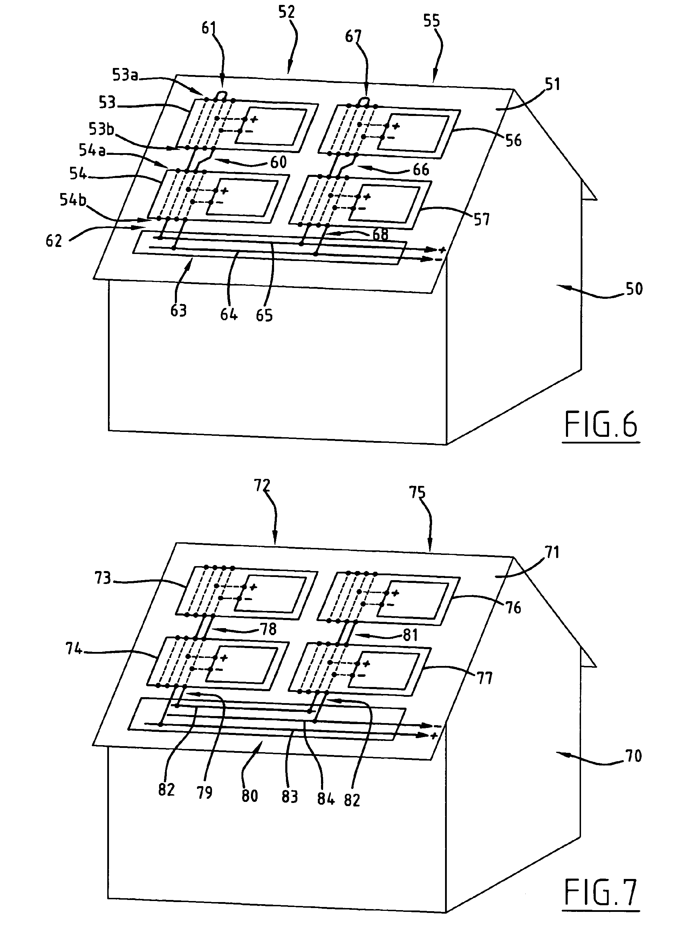

Un premier mode de réalisation d'un montage est représenté à la figure 6. Sur cette figure, il est prévu sur le toit 51 du bâtiment 50 un premier groupe 52 de deux panneaux 53, 54 montés en série, et un deuxième groupe 55 de deux panneaux 56 et 57 également montés en série. Les deux groupes de panneaux 52 et 55 sont branchés en parallèle sur un circuit 63 d'alimentation d'une utilisation. Pour assurer un tel montage, le moyen de connexion externe 53a du panneau 53 situé à l'extrémité du groupe 52 comporte un moyen de connexion 61 permettant de connecter un circuit relié au pôle + du générateur photovoltaïque du panneau 53 à un circuit de retour.

De la même façon, le connecteur externe 53b du cadre 53 et le connecteur externe 54a du panneau 54, qui sont en regard l'un de l'autre, sont reliés par un moyen de connexion intermédiaire 60 qui permet de connecter le pôle + du générateur du panneau 54 avec le pôle - du générateur du panneau 53, et le circuit de retour du panneau 53 avec le circuit de retour du panneau 54.

Enfin, le moyen de connexion externe 54b du panneau 54 est relié par l'intermédiaire d'un moyen de connexion intermédiaire 62 avec le circuit d'alimentation d'une utilisation 63, de telle sorte que le pôle - du générateur du panneau 54 est relié à un pôle - du circuit d'utilisation, et le circuit de retour qui est relié au pôle + du générateur du panneau 53 est relié au pôle + du circuit d'utilisation.

De la même façon, le groupe 55 de deux panneaux 56 et 57 comporte des moyens de connexion d'extrémité 67 et intermédiaire 66 et 68 qui permettent de monter les deux générateurs en série et de les monter sur le circuit d'utilisation en parallèle avec le générateur constitué par les panneaux 53 et 54.

Le circuit d'utilisation comprend une ligne 64 correspondant au pôle négatif et une ligne 65 correspondant pour le pôle positif.

De tels montages sont connus de l'homme du métier.

Dans un deuxième mode de réalisation, représenté à la figure 7, il est disposé sur le toit 71 d'un bâtiment 70, un premier groupe 72 de panneaux 73 et 74 qui sont montés en parallèle, et un deuxième groupe 75 de panneaux 76 et 77 qui sont également montés en parallèle. Les panneaux 73, 74 sont montés en parallèle par l'intermédiaire d'un connecteur intermédiaire 78. De même, les panneaux 76, 77 sont montés en parallèle par l'intermédiaire d'un connecteur 81.

Des ensembles de panneaux 72 et 75 sont montés en série avec le circuit d'utilisation par l'intermédiaire des connecteurs 79 et 82 qui les relient d'une part à une ligne 82 de connexion des pôles + de l'ensemble 75 avec les pôles - de l'ensemble de panneaux 72. Une ligne 83 correspondant au pôle + du circuit d'utilisation est reliée au pôle + des panneaux 73 et 74, par le connecteur 79. Une ligne 84 correspondant au pôle - du circuit d'utilisation est reliée par l'intermédiaire du connecteur 82 avec le pôle - des panneaux 76 et 77.

De tels montages donnés à titre d'exemples non limitatifs sont également connus de l'homme du métier.

En particulier, il doit être prévu des raccordements pour mettre à la masse les bâtis.

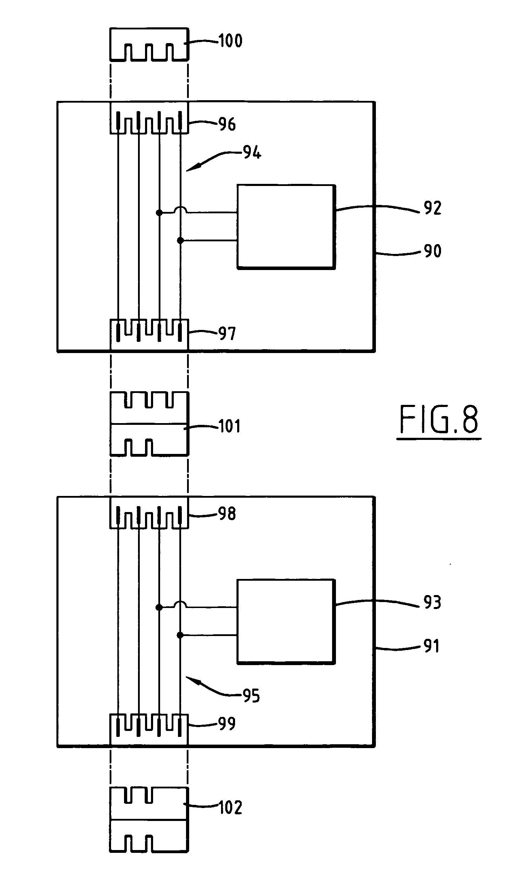

Ces montages sont représentés d'une façon schématique à la figure 8 où on a représenté deux panneaux 90 et 91 comportant chacun des éléments générateurs 92 et 93 et des câbles de connexion interne 94 et 95 pour relier le générateur du panneau 90 à des moyens de connexion externe 96 et 97, et celui du panneau 91 à des moyens de connexion externe 98 et 99. Le moyen de connexion externe 96 du panneau 90 reçoit un moyen de connexion d'extrémité 100 qui vient s'enficher dans le moyen de connexion externe 96. Ce moyen de connexion d'extrémité est destiné, si cela est nécessaire, comme dans le cas du premier mode de réalisation décrit précédemment, à assurer la jonction entre un pôle du générateur 92 et le circuit de retour.

Les deux moyens de connexions externes 97 et 98 des panneaux 92 et 91 qui sont en regard l'un de l'autre sont connectés par l'intermédiaire d'un moyen de liaison électrique extérieure 101 qui peut s'enficher d'une part dans le moyen de connexion 97 et d'autre part dans le moyen de connexion 98 pour assurer la liaison entre les deux panneaux selon le mode représenté dans le premier mode de réalisation ou dans le deuxième mode de réalisation décrits précédemment.

Enfin, le moyen de connexion externe 99 du panneau 91 comporte un moyen de connexion 102 au circuit d'alimentation de l'utilisation de l'électricité fournie.

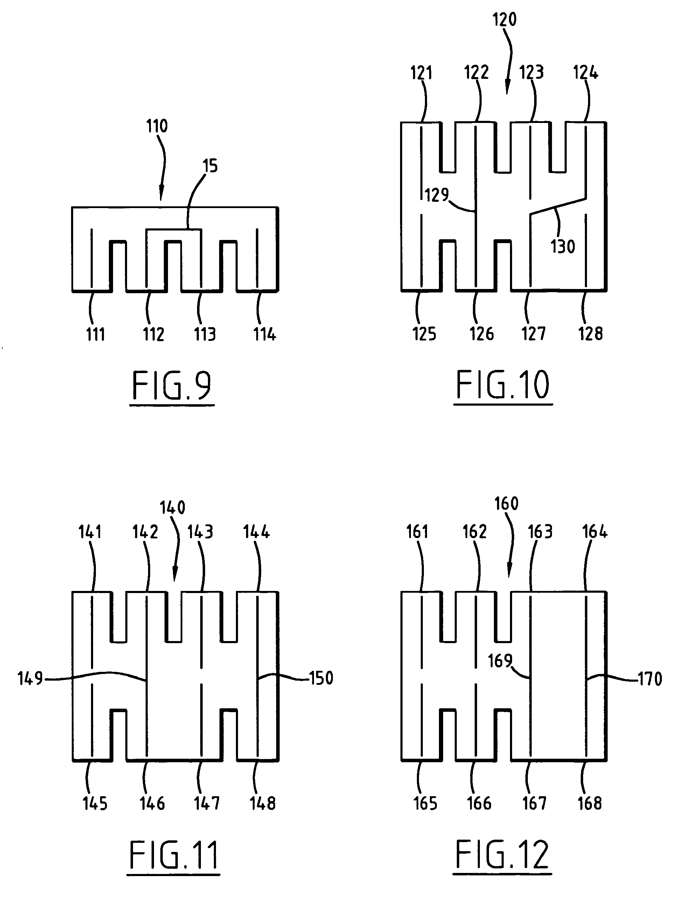

Ces moyens de liaison électrique ou de connexion 100, 101 et 102 sont conçus de façon à pouvoir s'enficher directement dans les moyens de connexion externe 96 et 97 avec des dispositions particulières permettant d'éviter la confusion entre les différents moyens de connexion. Ces moyens de connexion qui sont constitués de pièces, par exemple en matière plastique moulée, comportant à l'intérieur des fiches conductrices d'électricité ayant des formes adaptées pour pouvoir s'enficher dans les moyens de connexion externes 96 et 97, peuvent présenter plusieurs formes qui sont représentées aux figures 9, 10, 11 et 12.

A la figure 9, on a représenté de façon schématique un moyen de liaison électrique extérieure 110 destiné à assurer la jonction d'un pôle d'un générateur d'un panneau photovoltaïque et du circuit de retour en extrémité d'une série de panneaux montés en série, comme cela est représenté à la figure 6.

Cet élément de connexion comporte quatre plots 111, 112, 113 et 114 qui contiennent un cavalier conducteur électrique 15 qui permet de faire la jonction entre le plot intermédiaire 112 et le plot intermédiaire 113.

Les moyens de connexion intermédiaire entre deux panneaux, tels que le moyen de connexion intermédiaire 101 de la figure 8, peuvent prendre différentes formes selon la nature des liaisons électriques que l'on veut assurer.

A la figure 10, on a représenté un connecteur 120 qui constitue un moyen de liaison électrique extérieure qui permet d'assurer une liaison du type de la liaison 60, représentée à la figure 6, et qui comporte d'un côté quatre plots 121, 122, 123, 124 et de l'autre côté deux plots séparés 125 et 126 et deux plots réunis ensemble 127 et 128.

A l'intérieur de ces plots, en matière plastique, le connecteur comprend d'une part une jonction 129 entre un plot 122 et un plot 126 en regard l'un de l'autre afin d'assurer les jonctions entre les circuits de retour des panneaux et, une troisième jonction 130 qui permet d'assurer la liaison entre un plot d'extrémité 124 d'un côté et un plot intermédiaire 127 de l'autre, de façon à pouvoir assurer la jonction entre un pôle + d'un premier panneau et un pôle - d'un autre panneau. Les plots 127 et 128 sont réunis de façon à assurer un moyen de reconnaissance de la nature du connecteur.

Un deuxième type de connecteur, représenté à la figure 11, peut être utilisé pour assurer la jonction 62 entre un panneau 54 et le circuit d'utilisation 63, tel que représenté à la figure 6.

Ce connecteur 140 comporte d'un côté des plots 141, 142, 143, 144, séparés les uns des autres, et de l'autre côté un plot 145 séparé de deux plots 146 et 147 réunis et un plot 148. A l'intérieur du connecteur des moyens de jonction conducteurs 149 et 150 permettent de relier d'une part les plots 142 et 146, d'autre part les plots 144 et 148 de façon à assurer les jonctions telles que représentées à la connexion 62 de la figure 6.

Les deux plots 146 et 147 sont réunis dans un même ensemble de façon à assurer également un moyen de reconnaissance du connecteur.

Un troisième mode de réalisation d'un connecteur, représenté à la figure 12, peut être utilisé pour réaliser des connexions du type des connexions 78, 79, 81 ou 82, représentées à la figure 7, qui permettent d'assurer des jonctions entre deux panneaux adjacents ou d'un panneau avec le circuit d'utilisation lorsque deux panneaux adjacents sont montés en parallèle.

Ce connecteur 160 comporte d'un côté des plots 161, 162, 163 et 164, et de l'autre côté des plots 165, 166 et 167 et 168.

Les plots 163 et 167 en regard l'un de l'autre sont reliés par un moyen de jonction conducteur 169 et les plots 164 et 168 en regard l'un de l'autre sont reliés entre eux par un moyen de jonction conducteur 170.

Les plots 163 et 164, d'une part, et 167 et 168, d'autre part, sont réunis en un seul ensemble en matière plastique de façon également à assurer un moyen de reconnaissances des moyens de connexion.

Les connecteurs qui viennent d'être décrits comportent quatre couples de plots dont seuls trois sont utilisés.

Mais, le quatrième couple de plot peut également être utilisé, par exemple, pour réaliser une mise à la masse. Dans ce cas, les plots associés sont électriquement connectés.

On comprendra que ces moyens de connexion qui ne sont donnés qu'à titre d'exemple, sont des moyens standards qui peuvent être utilisés pour monter aisément par exemple les cadres sur un toit ou sur une paroi quelconque d'un bâtiment.

En effet, lorsque l'on connaît le mode de branchement que l'on souhaite réaliser, on peut choisir les moyens de connexion adaptés et on peut, en commençant par le bas, implanter sur les plots de connexion du le circuit 63 ou 80 de collecte du courant électrique, des moyens de connexion intermédiaire adaptés. Une fois que ces moyens de connexion intermédiaire sont implantés, on peut mettre en place un premier panneau en assurant l'enfichage du moyen de connexion à l'intérieur du moyen de connexion externe correspondant du panneau. Une fois le panneau fixé, on peut enficher sur le deuxième moyen de connexion externe du panneau, un moyen de connexion intermédiaire adapté. Puis, on peut mettre en place un deuxième panneau en s'assurant de faire en sorte que le moyen de connexion intermédiaire s'enfiche bien avec le moyen de connexion intermédiaire du deuxième panneau, puis on peut continuer ainsi de suite et réaliser une colonne de panneaux connectés entre eux par l'intermédiaire de moyens de connexion intermédiaire standardisés qu'il est facile de mettre en place.

On peut alors réaliser plusieurs colonnes de panneaux connectés entre eux comme on vient de l'indiquer, et on peut réaliser ainsi de façon aisé, un générateur électrique constitué d'une pluralité de panneaux photovoltaïques montés sur la paroi du bâtiment. Cette mise en place demande un minimum de mains d'oeuvre.

L'homme du métier comprendra que le principe de montage peut être aussi utilisé pour d'autres panneaux électriquement actifs que des panneaux photovoltaïques et, en particulier, il peut être prévu des moyens de connexion qui permettent d'assurer des commandes indépendantes de chacun des panneaux en les reliant à un circuit de commande général qui permet d'alimenter séparément chacun des panneaux, de les commander et ainsi en utilisant, par exemple, des panneaux susceptibles de devenir électroluminescent, d'assurer des effets esthétiques.

## Revendications

1. Bâti support d'un panneau électriquement actif, du type comprenant une structure périphérique (1) destinée à recevoir un panneau électriquement actif (20),
dont la structure périphérique (1) comprend un moyen de connexion électrique intérieur (14) permettant la connexion avec un panneau électriquement actif (20) porté par le bâti, au moins un premier moyen de connexion électrique extérieur (16) permettant une connexion avec un premier moyen extérieur au bâti, et des moyens de liaison électrique (18) pour relier électriquement au moins le moyen de connexion électrique intérieur (14) avec au moins le premier moyen de connexion électrique extérieur (16), les moyens de liaison électrique (18) s'étendant le long de la structure périphérique afin d'être dissimulé par la structure périphérique, la structure périphérique comprenant une partie creuse (25) dans laquelle les moyens de liaison électrique (18) sont reçus, la structure périphérique (1) étant un cadre constitué de montants tubulaires (2, 3, 4, 5), **caractérisé en ce que** les moyens de connexion électrique intérieur (14) et extérieur (16, 17) s'étendent à travers une paroi des montants sur lesquels il sont disposés et les moyens de liaison électrique (18) s'étendent à l'intérieur des montants tubulaires.

2. Bâti support d'un panneau électriquement actif selon la revendication 1, **caractérisé en ce que** les montants (2, 3, 4, 5) comportent une gorge (11) s'étendant le long d'une de leur génératrice, orientée vers l'intérieur du cadre, et destinée à recevoir le bord d'un panneau électriquement actif (20).

3. Bâti support d'un panneau électriquement actif selon la revendication 2, **caractérisé en ce qu'**au moins un montant (2, 5) comporte sur toute sa longueur au moins un volet (9, 10) s'étendant vers l'extérieur du cadre.

4. Bâti selon l'une quelconque des revendications 1 à 3, **caractérisé en ce que** la partie centrale (26) délimitée par la structure périphérique est ouverte.

5. Bâti selon la revendication 4, **caractérisé en ce qu'**il est constitué d'une bande métallique (30) découpée, pliée et assemblée par soudage.

6. Bâti selon la revendication 5, **caractérisé en ce que** la bande métallique (30) est constituée d'un alliage inoxydable et/ou d'un alliage ayant un coefficient de dilatation compatible avec le verre.

7. Bâti selon l'une quelconque des revendications 1 à 6, **caractérisé en ce qu'**il comprend deux moyens de connexion électrique extérieur (16, 17) comprenant chacun au moins trois bornes (16a, 16b, 16c, 16d ;17a, 17b, 17c, 17d) et **en ce que** le moyen de connexion électrique intérieur (14, 201) comporte au moins deux bornes (14a, 14b), chaque borne (14a, 14b) du moyen de connexion électrique intérieur (14) étant relié à une borne (16a, 16b, 17a, 17b) de chacun des moyens de connexion électrique extérieure (16, 17) et **en ce que** chaque borne d'un moyen de connexion électrique extérieure (16, 17), non reliée à une borne du moyen de connexion électrique intérieure, est reliée électriquement à une borne de l'autre moyen de connexion électrique extérieure, non reliée à une borne du moyen de connexion électrique intérieur.

8. Bâti selon la revendication 7, **caractérisé en ce que** le connecteur électrique intérieur (201) comprend au moins deux demi-boucles femelles élastiques (206) dans lesquelles des plots de connexion mâle (215) d'un panneau électrique actif peuvent être enfichés.

9. Bâti selon la revendication 7 ou la revendication 8, **caractérisé en ce que** le panneau électriquement actif (20) est un générateur photovoltaïque.

10. Paroi extérieure (51, 71) d'un bâtiment (50, 70), **caractérisée en ce qu'**elle comporte une pluralité de bâtis (53, 54, 56, 57 ;73, 74, 76, 77) selon l'une quelconque des revendications 1 à 8 disposés les uns à côté des autres, et **en ce que** au moins deux bâtis adjacents (53, 54, 56, 57 ;73, 74, 76, 77) sont connectés entre eux par un moyen de liaison électrique extérieur (60, 66 ; 78, 81) coopérant d'une part avec un moyen de connexion électrique extérieur (53b) d'un bâti (53) et d'autre part avec un moyen de connexion extérieur (54b) de l'autre bâti (54).

11. Paroi extérieure (51, 71) d'un bâtiment (50, 70) selon la revendication 10, **caractérisée en ce que** au moins un bâti porte un panneau électriquement actif.

12. Paroi extérieure (51, 71) d'un bâtiment (50, 70) selon la revendication 11, **caractérisée en ce que** le panneau électriquement actif est un générateur photovoltaïque.

13. Paroi extérieure (51, 71) d'un bâtiment (50, 70) selon l'une quelconque des revendications 10 à 12, **caractérisée en ce qu'**elle constitue un élément de toiture.

## Claims

1. Supporting frame for an electrically active panel comprising a peripheral structure (1) for receiving an electrically active panel (20),
the peripheral structure (1) of which comprises an internal electrical connection means (14) for connection to an electrically active panel (20) carried by the frame, at least one first external electrical connection means (16) for connection to a first means external to the frame, and electrical linking means (18) for electrically, linking at least the internal electrical connection means (14) to at least the first external electrical connection means (16), the electrical linking means (18) extending along the peripheral structure so as to be concealed by the peripheral structure, the peripheral structure comprising a hollow portion (25) in which the electrical linking means (18) are received, the peripheral structure (1) being a framework consisting of tubular uprights (2, 3, 4, 5), **characterized in that** the internal electrical connection means (14) and external electrical connection means (16, 17) extend through a wall of the uprights on which they are disposed and the electrical linking means (18) extend inside the tubular uprights.

2. Supporting frame for an electrically active panel according to claim 1, **characterized in that** the uprights (2, 3, 4, 5) comprise a groove (11) which extends along one of their generatrices, is oriented towards the interior of the framework and is intended to receive the edge of an electrically active panel (20).

3. Supporting frame for an electrically active panel according to claim 2, **characterized in that** at least one upright (2, 5) comprises, over its entire length, at least one flap (9, 10) extending toward the exterior of the framework.

4. Frame according to any one of claims 1 to 3, **characterized in that** the central portion (26) delimited by the peripheral structure is open.

5. Frame according to claim 4, **characterized in that** it consists of a metal strip (30) which is cut out, folded and joined by welding.

6. Frame according to claim 5, **characterized in that** the metal strip (30) consists of a stainless alloy and/or an alloy having a coefficient of expansion compatible with glass.

7. Frame according to any one of claims 1 to 6, **characterized in that** it comprises two external electrical connection means (16, 17) each comprising at least three terminals (16a, 16b, 16c, 16d; 17a, 17b, 17c, 17d) and **in that** the internal electrical convection means (14, 201) comprises at least two terminals (14a, 14b), each terminal (14a, 14b) of the internal electrical connection means (14) being linked to a terminal (16a, 16b, 17a, 17b) of each of the external electrical connection means (16, 17) and **in that** each terminal of an external electrical connection means (16, 17) not linked to a terminal of the internal electrical connection means is electrically lined to a terminal of the other external electrical connection means not linked to a terminal of the internal electrical connection means.

8. Frame according to claim 7, **characterized in that** the internal electrical connector (201) comprises at least two resilient female half-loops in which male connecting studs (215) of an active electrical panel may be plugged.

9. Frame according to either claim 7 or claim 8, **characterized in that** the electrically active panel (20) is a photovoltaic generator.

10. External wall (51, 71) of a building (50, 70), **characterized in that** it comprises a plurality of frames (53, 54, 56, 57; 73, 74, 76, 77) according to any one of claims 1 to 8, disposed side by side, and **in that** at least two adjacent frames (53, 54, 56, 57; 73, 74, 76, 77) are connected to one another by an external electrical linking means (60, 66, 78, 81) which cooperates on the one hand with an external electrical connection means (53b) of a frame (53) and on the other hand with an external connection means (54b) of the other frame (54).

11. External wall (51, 71) of a building (50, 70) according to claim 10, **characterized in that** at least one frame carries an electrically active panel.

12. External wall (51, 71) of a building (50, 70) according to claim 11. **characterized in that** the electrically active panel is a photovoltaic generator.

13. External wall (51, 71) of a building (50, 70) according to any one of claims 10 to 12, **characterized in that** it forms a roof element.

## Patentansprüche

1. Unterstützungsrahmen für eine elektrisch aktive Platte des Typs, der eine Umfangsstruktur (1) aufweist, die dazu bestimmt ist, eine elektrisch aktive Platte (20) aufzunehmen,
wobei die Umfangsstruktur (1) ein inneres elektrisches Anschlussmittel (14), das die Verbindung mit einer elektrisch aktiven Platte (20) ermöglicht, die von dem Rahmen getragen wird, wenigstens ein erstes äußeres elektrisches Anschlussmittel (16), das eine Verbindung mit einem ersten äußeren Mittel des Rahmens ermöglicht, und elektrische Verbindungsmittel (18), um wenigstens das innere elektrische Anschlussmittel (14) wenigstens mit dem ersten äußeren elektrischen Anschlussmittel (16) elektrisch zu verbinden, umfasst, wobei sich die elektrischen Verbindungsmittel (18) längs der Umfangsstruktur erstrecken, um von der Umfangsstruktur verborgen zu werden, wobei die Umfangsstruktur einen hohlen Bereich (25) ausweist, in dem die elektrischen Verbindungsmittel aufgenommen sind, wobei die Umfangsstruktur (1) ein Rahmen ist, der aus rohrförmigen Streben (2, 3, 4, 5) gebildet ist, **dadurch gekennzeichnet, dass** die inneren elektrischen Anschlussmittel (14) und die äußeren elektrischen Anschlussmittel (16, 17) durch eine Wand der Streben, an denen sie angeordnet sind, verlaufen und die elektrischen Verbindungsmittel (18) innerhalb der rohrförmigen Streben verlaufen.

2. Unterstützungsrahmen für elektrisch aktive Platte nach Anspruch 1, **dadurch gekennzeichnet, dass** die Streben (2, 3, 4, 5) eine Kehle (11) aufweisen, die sich längs einer ihrer Erzeugenden erstreckt und in den Innenraum des Rahmens orientiert ist und dazu bestimmt ist, den Rand einer elektrisch aktiven Platte (20) aufzunehmen.

3. Unterstützungsrahmen für elektrisch aktive Platte nach Anspruch 2, **dadurch gekennzeichnet, dass** wenigstens eine Strebe (2, 5) auf ihrer gesamten Länge wenigstens eine Klappe (9, 10) aufweist, die sich in die äußere Umgebung des Rahmens erstreckt.

4. Rahmen nach einem der Ansprüche 1 bis 3, **dadurch gekennzeichnet, dass** der Mittelteil (26), der durch die Umfangsstruktur begrenzt ist, offen ist.

5. Rahmen nach Anspruch 4, **dadurch gekennzeichnet, dass** er aus einem gestanzten Metallband (30), das gebogen und durch Schweißen zusammengefügt ist, gebildet ist.

6. Rahmen nach Anspruch 5, **dadurch gekennzeichnet, dass** das Metallband (30) aus einer rostfreien Legierung und/oder aus einer Legierung mit einem Ausdehnungskoeffizienten, der mit Glas kompatibel ist, gebildet ist.

7. Rahmen nach einem der Ansprüche 1 bis 6, **dadurch gekennzeichnet, dass** er zwei äußere elektrische Anschlussmittel (16, 17) umfasst, die jeweils weinigstens drei Anschlussorgane (16a, 16b, 16c, 16d; 17a, 17b, 17c, 17d) enthalten, und dass das innere elektrisch Anschlussmittel (14, 201) wenigstens zwei Anschlussorgane (14a, 14b) aufweist, wobei jedes Anschlussorgan (14a, 14b) des inneren elektrischen Anschlussmittels (14) mit einem Anschlussorgan (14a, 16b, 17a, 17b) jedes der äußeren elektrischen Anschlussmittel (16, 17) verbunden ist und dass jedes Anschlussorgan eines äußeren elektrischen Anschlussmittels (16, 17), die nicht mit einem Anschlussorgan des inneren elektrischen Anschlussmittels verbunden ist, mit einem Anschlussorgan eines anderen äußeren elektrischen Anschlussmittels, das nicht mit einem Anschlussorgan des inneren elektrischen Anschlussmittels verbunden ist, verbunden ist.

8. Rahmen nach Anspruch 7, **dadurch gekennzeichnet, dass** der innere elektrische Verbinder (201) wenigstens zwei elastische Steckhalbringe (206) aufweist, in die Steckverbindungsstifte (215) einer elektrisch aktiven Platte gesteckt werden können.

9. Rahmen nach Anspruch 7 oder Anspruch 8, **dadurch gekennzeichnet, dass** die elektisch aktive Platte (20) ein photovoltaischer Generator ist.

10. Außenwand (51, 71) eines Gebäudes (50, 70), **dadurch gekennzeichnet, dass** sie mehrere Rahmen (53, 54, 56, 57; 73, 74, 76, 77) nach einem der Ansprüche 1 bis 8 aufweist, die nebeneinander angeordnet sind, und dass wenigstens zwei benachbarte Rahmen (53, 54, 56, 57; 73, 74, 76, 77) miteinander durch ein äußeres elektrisches Verbindungsmittel (60, 66; 78, 81) verbunden sind, das einerseits mit einem äußeren elektrischen Anschlussmittel (53b) eines Rahmens (53) zusammenwirkt und andererseits mit einem äußeren Anschlussmittel (54b) das anderen Rahmens (54) zusammenwirkt.

11. Außenwand (51, 71) eines Gebäudes (50, 70) nach Anspruch 10, **dadurch gekennzeichnet, dass** wenigstens ein Rahmen eine elektrisch aktive Platte trägt.

12. Außenwand (51, 71) eines Gebäude (50, 70) nach Anspruch 1 **dadurch gekennzeichnet, dass** die elektrisch aktive Platte ein photovoltaischer Generator ist.

13. Außenwand (51, 71) eines Gebäudes (50, 70) nach einem der Ansprüche 10 bis 12, **dadurch gekennzeichnet, dass** sie ein Dachelement bildet.
